(19) 

Europäisches
Patentamt
European
Patent Office
Office européen
des brevets

(11) **EP 1 429 400 B1**

(12) **EUROPEAN PATENT SPECIFICATION**

(45) Date of publication and mention
of the grant of the patent:
**26.08.2009 Bulletin 2009/35**

(51) Int Cl.:
*H01M 2/00* (2006.01)    *C08F 8/28* (2006.01)
*C08F 216/38* (2006.01)

(21) Application number: **02765606.5**

(22) Date of filing: **20.09.2002**

(86) International application number:
**PCT/JP2002/009669**

(87) International publication number:
**WO 2003/028143 (03.04.2003 Gazette 2003/14)**

(54) **MODIFIED POLYVINYL ACETAL RESIN**

MODIFIZIERTES POLYVINYLACETALHARZ

RESINE D'ACETAL POLYVINYLIQUE MODIFIE

(84) Designated Contracting States:
**BE DE FR GB IT**

(30) Priority: **21.09.2001   JP 2001289367**
**21.09.2001   JP 2001289368**

(43) Date of publication of application:
**16.06.2004   Bulletin 2004/25**

(73) Proprietor: **SEKISUI CHEMICAL CO., LTD.**
**Osaka-shi,**
**Osaka 530-8565 (JP)**

(72) Inventors:
• **MIYAKE, Yoshitaka**
**c/o Sekisui Chemical Co., Ltd.**
**Koka-gun, Shiga 528-8585 (JP)**

• **SAWADA, Masakazu**
**c/o Sekisui Chemical Co., Ltd.**
**Koka-gun, Shiga 528-8585 (JP)**

(74) Representative: **Hubert, Philippe et al**
**Cabinet Beau de Loménie**
**158, rue de l'Université**
**75340 Paris Cédex 07 (FR)**

(56) References cited:
JP-A- 9 077 822          JP-A- 53 065 386
JP-A- 60 054 967         JP-A- 62 059 551
JP-A- 63 079 741         JP-A- 63 079 752
JP-B- 48 032 779         US-A- 2 636 803
US-A- 4 212 956

**Description**

The present invention uses a modified polyvinyl acetal resin, which is superior in flexibility, an adhesive property to a resin substrate under high humidities, heat resistance, a thermal decomposition property, humidity resistance and toughness and, has low oxygen permeability and an adequate adhesive property and is low in viscosity and high in secular stability of viscosity in forming a solution thereof, and is directed to a slurry composition for a ceramic green sheet, and a ceramic green sheet, which use the modified polyvinyl acetal resin.

BACKGROUND ART

Conventionally, polyvinyl acetal resins such as a polyvinyl butyral resin have been used in various applications such as ink, coating materials, baking enamels, wash primers, lacquers, dispersants, adhesives, ceramic green sheets, thermal developing photosensitive materials, binders of water-based ink acceptance layers, etc. since they have high toughness, a high film forming property, high dispersibility of organic/inorganic powder of pigment or the like, and high adhesion to the surface to be coated.

The primary reason why the polyvinyl acetal resin is used in various applications like this is that a hydroxyl group exists in a polyvinyl acetal resin and therefore the polyvinyl acetal resin has toughness by virtue of a hydrogen bond of the hydroxyl group, but nevertheless the polyvinyl acetal resin becomes low in flexibility to some extent due to the hydrogen bond.

On the other hand, for example in Japanese Kokai Publication Hei-6-263521, there is disclosed an technique of realizing internal plasticization of a polyvinyl acetal resin by introducing a unit having a glycolic structure with a long chain into a side chain of the polyvinyl acetal resin. However, the flexibility of the polyvinyl acetal resin was improved by the introduction of a long chain, but there has been a problem that the solution viscosity of the resin in being dissolved in a solvent became high or a storage stability in a solution was poor and the viscosity thereof increased with the passage of time.

And, particularly in recent years, the frequency of uses of polyvinyl acetal resins, which does not use toluene, xylene or the like of an aromatic solvent and has high solubility in an alcoholic single solvent such as ethanol, propanol, has increased from the viewpoint of environmental protection. In terms of environmental protection, there are three major tendencies of higher solid contents, increase in water-based substance and adoption of powder matter as seen in the regulations of VOC in automobiles. Particularly, higher solid contents does not require a capital investment compared with another two tendencies and it has a feature that the performances can be guessed from the conventional articles and assured since it only reduces an amount of solvents to be used and increase the solid content, and therefore this technique are addressed by many researchers. As a method of realizing the higher solid contents using a polyvinyl acetal resin, it is conceivable to increase the concentration of a solid content, that is, to increase the content of a binder, but when the concentration of a solid content is increased, there are problems usually that the solution viscosity increase and the secular stability of solution viscosity is deteriorate.

With respect to these problems, as a method of lowering the viscosity of the solution, there are given methods of lowering a polymerization degree, modifying a molecular structure or the like and a printing ink and a coating material, which contain polyvinyl butyral resin using polyvinyl alcohol having a saponification degree of 70 to 96 mole % as a raw material, are disclosed in Japanese Kokai Publication Hei-11-349889. However, this solution containing the polyvinyl butyral resin had lower viscosity but was not sufficient in secular stability of viscosity and in flexibility in the case of being used in films, and there was not description on adhesion to a substrate and another performances such as humidity resistance although there was a description that lower viscosity and higher solid contents could be realized by suppressing an amount of residual acetyl groups.

And, as one of uses of a polyvinyl acetal resin, there is given a laminated ceramic condenser.

When the laminated ceramic condenser is fabricated, it is generally fabricated through the following steps. First, a binder resin and a plasticizer are added to a dispersion formed by dispersing ceramic powder in an organic solvent, and the mixture is mixed homogeneously with a mixing apparatus such as a ball mill and deaerated to prepare a slurry composition. Then, the slurry composition is applied onto a releasable supporting member using a doctor blade, a three roll reverse coater, etc., and the applied slurry composition is heated to be dried and then the dried coating is peeled off from the supporting member to obtain a green sheet. A laminate is obtained by superposing two or more sheets of processed ceramic green sheets which is formed by applying a conductive paste to become an internal electrode onto the obtained ceramic green sheet by screen process printing and by thermally attaching the processed ceramic green sheet to another by pressure. A laminated ceramic condenser can be obtained by cutting the laminate to the predetermined shape and dimensions, and by sintering an external electrode on the end face of the ceramic sintered body obtained by sintering.

For such a green sheet, a polyvinyl acetal resin such as a polyvinyl butyral resin is used for improving handling, and for example, some polyvinyl acetal resins are disclosed in Japanese Kokai Publication Hei-3-197511, Japanese Kokai Publication Hei-3-200805, Japanese Kokai Publication Hei-4-175261, Japanese Kokai Publication Hei-4-178404 and the like.

In recent years, a compact laminated ceramic condenser with a large capacity is required as electronic equipment is downsized. As a method of responding to such a requirement, there is made attempts to superpose a thin layer ceramic green sheet (for example, a thickness of 3 $\mu$m or smaller), obtained by using ceramic powder having a particle diameter (for example, 0.3 $\mu$m or smaller) finer than a conventional one, by 500 sheets or more.

However, when ceramic powder has a smaller particle diameter, the surface area of powder increases and therefore an amount of a binder to be added needs to increase. Accordingly, since the viscosity of slurry became high, not only handling became difficult, but also there have been problems that the ceramic powder tended to flocculate and viscosity increased with time.

And, in order to superpose such a thin layer ceramic green sheet by 500 sheets or more, an adhesive property in being thermally attached to another by pressure, releasability from a supporting member and strength of a green sheet become very important. For example, in order to improve the ability of the green sheet to be thermally attached to another by pressure, it is effective to uses a polyvinyl acetal resin having a high acetalization degree and a small amount of a hydroxyl group, or having a low polymerization degree, but there was the case where the ceramic green sheet became difficult to be released from a supporting member and the green sheet was flexible and did not have the strength to be impervious to releasing in a releasing process, and as a result there have been problems that the green sheet broke or stretched extraordinarily. In order to improve the releasability from a supporting member and the strength of a green sheet, it is effective to uses a polyvinyl acetal resin having a low acetalization degree and a large amount of a hydroxyl group, or having a high polymerization degree, but there have been problems that since an adhesive property in being thermally attached to another by pressure was low, the green sheet peeled off from the surface of a laminate after being attached to another by pressure and in the case of using the polyvinyl acetal resin having a high polymerization degree, the viscosity of slurry became high and consequently the slurrying became difficult.

On the other hand, though it is also conceivable to improve the ability of the green sheet to be thermally attached to another by pressure by increasing the amount of a plasticizer to be added, there has been a problem in a storage stability of a green sheet since an excessive addition of a plasticizer caused a shrinkage rate in sintering to deteriorate or the plasticizer to bleed out with time in the case of storing as the green sheet.

And, when number of laminated layers is many, decomposition of a binder in a debinder process hardly proceeds thoroughly and a decomposition product of a binder remains as a residue in the ceramic green sheet and consequently this sometimes deteriorated electrical characteristics. Further, in a substrate such as low temperature cofired ceramic substrate (LTCC) which uses glass powder and a copper wire as an electrode, a binder needs to thermally decompose thoroughly at 500˚C or lower, electrical characteristics sometimes deteriorated when the thermal decomposition was not perfect. Here, the polyvinyl acetal resin had a problem that it had a poor thermal decomposition property and ash remained after sintering.

Furthermore, since a laminated ceramic condenser, in which a thinner layer of a green sheet has increased, becomes subject to an external environment of a green sheet, particularly moisture, there has been a problem that the strength and the flexibility of a sheet varied with time and a ratio of a conforming item was deteriorated when a hygroscopic binder was used.

Thus, it has been desired for the modified polyvinyl acetal resin that the solution viscosity thereof was reduced in response to higher solid contents for improvement in flexibility and an environmental protection and the secular stability of viscosity was improved. And, when the modified polyvinyl acetal resin is employed in a slurry composition for a ceramic green sheet, it has been required to improve a thermal decomposition property and humidity resistance, and when it is used in a green sheet, it has been required to have a balanced adhesive property in which an adhesive property and sheet strength in thermally attaching by pressure and releasability from a supporting member can go hand in hand.

## SUMMARY OF THE INVENTION

It is an object of the present invention to provide a modified polyvinyl acetal resin, which is superior in flexibility, an adhesive property to a resin substrate under high humidities, heat resistance, a thermal decomposition property, humidity resistance and toughness and has low oxygen permeability and an adequate adhesive property and is low in viscosity and high in secular stability of viscosity in forming a solution thereof for use in a slurry composition for a ceramic green sheet, and a ceramic green sheet, which use the modified polyvinyl acetal resin.

The first type of resin that may be used in the present invention is a modified polyvinyl acetal resin, which is obtainable by acetalizing a modified polyvinyl alcohol having ethylene in a random basis as a constituent unit of a main chain and an ethylene content of 1 to 20 mole % and a saponification degree of 80 mole % or more and, has ethylene in a random basis as a constituent unit of a main chain.

The second type of resin that may be used in the present invention is a modified polyvinyl acetal resin, which is obtainable by acetalizing a mixture of polyvinyl alcohols containing at least a modified polyvinyl alcohol having ethylene in a random basis as a constituent unit of a main chain and an ethylene content of 1 to 20 mole % as a whole and a saponification degree of 80 mole % or more as a whole and, has ethylene in a random basis as a constituent unit of a main chain.

Preferably, the modified polyvinyl acetal resins of the first type used in the present invention and the second type used in the present invention has an acetalization degree of 40 to 80 mole%, and is one acetalized by butyl aldehyde and/or acetaldehyde, and contains water in an amount of 2.5 weight % or less and aldehyde in an amount of 100 ppm or less.

The present invention is a slurry composition for a ceramic green sheet, which comprises the modified vinyl acetal resin of the first type used in the present invention or the second type used in the present invention, ceramic powder, a plasticizer and an organic solvent. A ceramic green sheet which is obtainable by using the slurry composition for a ceramic green sheet of the present invention is also one of the present invention.

DETAILED DISCLOSURE OF THE INVENTION

Hereinafter, the present invention will be described in detail.

A modified polyvinyl acetal resin of the first type used in the present invention is obtainable by acetalizing a modified polyvinyl alcohol and has ethylene in a random basis as a constituent unit of a main chain. By having ethylene in a random basis as a constituent unit of a main chain, the modified polyvinyl acetal resin can reduce the viscosity of a solution thereof and attain effects of obtaining the secular stability of viscosity and improving flexibility, heat resistance, an adhesive property, humidity resistance, a thermal decomposition property, solvent solubility and the like.

Here, in this specification, having ethylene in a random basis as a constituent unit of a main chain means that all of ethylene units in a molecule are not combined into one but ethylene units in a molecule are located in a state of being separated into two or more parts in main chain.

And, it is possible to verify through, for example, a glass transition temperature measured with a differential scanning calorimeter or solubility in an organic solvent that the modified polyvinyl acetal resin of the first type used in the present invention has ethylene in a random basis as a constituent unit of a main chain. In measuring the above-mentioned glass transition temperature, only one glass transition temperature appears when the modified polyvinyl acetal resin has ethylene in a random basis as a constituent unit of a main chain, and two glass transition temperatures appear when the ethylene units exist in a state of a block. In verification through the above-mentioned solubility in an organic solvent, when the modified polyvinyl acetal resin has ethylene in a random basis as a constituent unit of a main chain, it is dissolved thoroughly in an organic solvent such as a mixed solution of ethanol and toluene having a weight ratio of 1:1, methyl ethyl ketone, etc. When the ethylene units exist in a state of a block, the modified polyvinyl acetal resin is low in the solubility in an organic solvent and generates an undissolved matter in being dissolved.

The above-mentioned modified polyvinyl alcohol is not particularly limited as long as it has ethylene in a random basis as a constituent unit of a main chain, and for example, a substance formed by saponifying a copolymer of vinyl ester and ethylene, a substance formed by saponifying a copolymer of vinyl ester, ethylene and ethylenic unsaturated monomer, end modified polyvinyl alcohol and the like are given. Because the above-mentioned modified polyvinyl alcohol has ethylene in a random basis as a constituent unit of a main chain, water solubility required for performing an acetalization reaction is enhanced and the modified polyvinyl acetal resin, which is obtained by acetalization, of the first type used in the present invention has ethylene in a random basis as a constituent unit of a main chain.

Further, the randomness of an ethylene unit in a main chain of the above-mentioned modified polyvinyl alcohol can be controlled by adjusting, for example, a polymerization initiator, a polymerization temperature, an addition technique of monomer, a polymerization time and the like in copolymerization. And, it is possible to verify through, for example, water solubility that the modified polyvinyl alcohol has ethylene in a random basis as a constituent unit of a main chain. When the modified polyvinyl alcohol has ethylene in a random basis as a constituent unit of a main chain, it is dissolved thoroughly in water, and when the ethylene units exist in a state of a block, the modified polyvinyl alcohol is low in water solubility and generates an undissolved matter in being dissolved in water.

The above-mentioned vinyl ester is not particularly limited and, for example, vinyl formate, vinyl acetate, vinyl propionate, vinyl pivalate and the like are given. Among them, vinyl acetate is economically preferable.

The above-mentioned ethylenic unsaturated monomer is not particularly limited, and for example, acrylic acid, methacrylic acid, phthalic acid, phthalic anhydride, maleic acid, maleic anhydride, itaconic acid, itaconic anhydride, acrylonitrile, methacrylonitrile, acrylamide, methacrylamide, trimethyl-(3-acrylamide-3-dimethylpropyl)-ammonium chloride, acrylamide-2-methylpropanesulfonic acid and sodium salt thereof, ethyl vinyl ether, butyl vinyl ether, N-vinylpyrrolidone, vinyl chloride, vinyl bromide, vinyl fluoride, vinylidene chloride, vinylidene fluoride, tetrafluoroethylene, vinylsulfonic acid sodium, allylsulfonic acid sodium and the like are given.

The above-mentioned end modified polyvinyl alcohol is formed by saponifying a copolymer of vinyl ester monomer such as vinyl acetate and ethylene in the presence of a thiol compound of thiol acid such as thiolacetic acid and mercaptopropione acid.

An blending amount of ethylenic unsaturated monomer, which is blended in preparing a copolymer of the above vinyl ester, ethylene and ethylenic unsaturated monomer, is preferably less than 2.0 mole %. When many units derived from ethylenic unsaturated monomer is contained, modified polyvinyl alcohol hardly has sufficient water solubility and in forming a solution of the modified polyvinyl acetal resin of the first type used in the present invention, the secular stability of viscosity may become poor. Particularly, the above-mentioned modified polyvinyl alcohol is preferably one which does not contain units derived from ethylenic unsaturated monomer.

The above-mentioned modified polyvinyl alcohol has an ethylene content of 1 to 20 mole %. When the ethylene content is less than 1 mole %, the flexibility and the heat resistance of the modified polyvinyl acetal resin of the first type used in the present invention are deteriorated, and the modified polyvinyl acetal resin has a small effect of lowering viscosity in forming a solution thereof and is low in secular stability of viscosity, and cannot adequately attain effects of improving an adhesive property, humidity resistance and a thermal decomposition property. When it is more than 20 mole %, since the water solubility of the modified polyvinyl alcohol is lowered, an acetalization reaction becomes difficult, or the modified polyvinyl acetal resin of the first type used in the present invention to be obtained has lower solvent solubility, or lower secular stability of viscosity of a solution thereof. Incidentally, in this specification, an ethylene content represents a ratio of number of ethylene units to total number of monomer units composing the modified polyvinyl alcohol.

Because the above-mentioned modified polyvinyl alcohol has the ethylene content of 1 to 20 mole %, the modified polyvinyl acetal resin of the first type used in the present invention, which is obtained by acetalizing the modified polyvinyl alcohol, also has an ethylene content of 1 to 20 mole %.

The above-mentioned modified polyvinyl alcohol has a saponification degree of 80 mole % or higher. When the saponification degree is lower than 80 mole %, an acetalization reaction becomes difficult since the water solubility of the modified polyvinyl alcohol is lowered and an acetalization reaction itself becomes difficult since number of hydroxyl groups becomes less.

The above-mentioned acetalization can be conducted by adding aldehyde to an aqueous solution of the above-mentioned modified polyvinyl alcohol and following a publicly known method.

The above-mentioned aldehyde is not particularly limited, and for example, formaldehyde (including p-formaldehyde), acetaldehyde (including p-acetaldehyde), propionaldehyde, butylaldehyde, amylaldehyde, hexyl aldehyde, heptyl aldehyde, 2-ethylhexyl aldehyde, cyclohexyl aldehyde, furfural, glyoxal, glutaraldehyde, benzaldehyde, 2-methylbenzaldehyde, 3-methylbenzaldehyde, 4-methylbenzaldehyde, p-hydroxybenzaldehyde, m-hydroxybenzaldehyde, phenylacetaldehyde, β-phenylpropionaldehyde and the like are given. Among them, acetaldehyde and/or butylaldehyde is favorably used. These aldehyde may be used alone or in combination of two or more species.

An acetalization degree of the modified polyvinyl acetal resin of the first type used in the present invention is preferably 40 to 80 mole% whether the acetalization is performed by a kind of aldehyde or by a mixture of two or more kinds of aldehydes. When the acetalization degree is less than 40 mole%, the modified polyvinyl acetal resin of the first type used in the present invention become soluble in water and insoluble in an organic solvent. When it is more than 80 mole%, number of residual hydroxyl groups becomes less and the toughness of the modified polyvinyl acetal resin of the first type used in the present invention may be impaired. In addition, a more favorable range may be selected for the above-mentioned acetalization degree, depending on uses of the modified polyvinyl acetal resin of the first type used in the present invention.

Incidentally, in this specification, because an acetal group is formed from two hydroxyl groups by acetalization, the acetalization degree refers to an acetalization degree (mole %) in the case of counting an acetal group as two hydroxyl groups to calculate the acetalization degree.

An polymerization degree of the modified polyvinyl acetal resin of the first type used in the present invention is not particularly limited but it is preferably 50 to 3,500. When the polymerization degree is within this range, it is possible to produce the modified polyvinyl acetal resin of the first type used in the present invention and the above-mentioned modified polyvinyl alcohol with high productivity. The polymerization degree is more preferably 200 to 3,500. In addition, a more favorable range may be selected for the above-mentioned polymerization degree, depending on uses of the modified polyvinyl acetal resin of the first type used in the present invention.

A water content of the modified polyvinyl acetal resin of the first type used in the present invention is preferably 2.5 weight % or lower. As a method of reducing the above-mentioned water content to 2.5 weight % or lower, there is given a method of cleaning a product after an acetalization reaction with water or a mixed solution of water and alcohol and then reducing the water content below a specified level by drying. It is more preferably 2.0 weight % or lower.

An amount of aldehyde of the modified polyvinyl acetal resin of the first type used in the present invention is preferably 100 ppm or lower. As a method of reducing the above-mentioned amount of aldehyde to 100 ppm or lower, there is given a method of purifying a product by cleaning with water or a mixed solution of water and alcohol to reduce the amount of aldehyde to a specified level or below. It is more preferably 50 ppm or lower, furthermore 10 ppm or lower.

As a specific method of producing the modified polyvinyl acetal resin of the first type used in the present inventions, there are given, for example, a method of dissolving the modified polyvinyl alcohol in a solvent, reacting the solution with a predetermined amount of aldehydes so as to provide the modified polyvinyl acetal resin with a desired acetalization degree in the presence of an acid catalyst, terminating an acetalization reaction with an alkali or a terminator, and then water washing and drying a product.

The above-mentioned solvent is not particularly limited and there is given, for example, water, alcohol, a mixed solvent of water and alcohol, dimethylsulfoxide (DMSO), etc.

The above-mentioned acid catalyst is not specifically limited and both of an organic acid and an inorganic acid can be used, and for example, acetic acid, p-toluene sulfonic acid, nitric acid, sulfuric acid, hydrochloric acid, etc. are given.

The above-mentioned alkali is not particularly limited and, for example, sodium hydroxide, potassium hydroxide, ammonium, sodium acetate, sodium carbonate, sodium hydrogencarbonate and potassium carbonate, etc. are given.

The above-mentioned terminator is not particularly limited and, for example, alkylene oxide such as ethylene oxide, glycidyl ether such as ethylene glycol diglycidyl ether and the like are given.

The modified polyvinyl acetal resin of the first type used in the present invention is formed by acetalizing a modified polyvinyl alcohol having ethylene in a random basis as a constituent unit of a main chain and having a predetermined ethylene content and a predetermined saponification degree, and since the hydrogen bond strength of a hydroxyl group contained in the modified polyvinyl acetal resin is weakened, a solution of the modified polyvinyl acetal resin has low viscosity and high secular stability of viscosity and can form a coat with high flexibility. Such the modified polyvinyl acetal resin of the first type used in the present invention can be effectively used in application areas such as ceramics.

The modified polyvinyl acetal resin of the second type used in the present invention is formed by acetalizing a mixture of polyvinyl alcohols and has ethylene in a random basis as a constituent unit of a main chain. By having ethylene in a random basis as a constituent unit of a main chain, the modified polyvinyl acetal resin can reduce the viscosity of a solution thereof and attain effects of obtaining the secular stability of viscosity and improving flexibility, heat resistance, an adhesive property, humidity resistance, a thermal decomposition property, solvent solubility and the like. Here, the modified polyvinyl acetal resin, having ethylene in a random basis as a constituent unit of a main chain, of the second type used in the present invention means a modified polyvinyl acetal resin containing modified polyvinyl acetal having ethylene in a random basis as a constituent unit of a main chain and may contain unmodified polyvinyl acetal in part. And, it is possible to verify through, for example, the glass transition temperature of modified polyvinyl acetal, which is measured with a differential scanning calorimeter, or the solubility of modified polyvinyl acetal in an organic solvent that the modified polyvinyl acetal in the modified polyvinyl acetal resin of the second type used in the present invention has ethylene in a random basis as a constituent unit of a main chain. In the above-mentioned measurement of the glass transition temperature, only one glass transition temperature appears when the modified polyvinyl acetal resin has ethylene in a random basis as a constituent unit of a main chain, and two glass transition temperatures appear when the ethylene units exist in a state of a block. In verification of the above-mentioned solubility in an organic solvent, when the modified polyvinyl acetal resin has ethylene in a random basis as a constituent unit of a main chain, it is dissolved thoroughly in an organic solvent such as a mixed solution of ethanol and toluene having a weight ratio of 1:1, methyl ethyl ketone, etc. When the ethylene units exist in a state of a block, the modified polyvinyl acetal resin is low in the solubility in an organic solvent and generates an undissolved matter in being dissolved.

The above-mentioned mixture of polyvinyl alcohols consists of two or more kinds of polyvinyl alcohols and contains at least modified polyvinyl alcohol having ethylene in a random basis as a constituent unit of a main chain and may contain unmodified polyvinyl alcohol.

The above-mentioned modified polyvinyl alcohol of the second type used in the present invention is not particularly limited as long as it has ethylene in a random basis as a constituent unit of a main chain, and for example, a substance formed by saponifying a copolymer of vinyl ester and ethylene, a substance formed by saponifying a copolymer of vinyl ester, ethylene and ethylenic unsaturated monomer, end modified polyvinyl alcohol and the like are given. Because the above-mentioned modified polyvinyl alcohol of the second type used in the present invention has ethylene in a random basis as a constituent unit of a main chain, water solubility required for performing an acetalization reaction is enhanced and the modified polyvinyl acetal resin, which is obtained by acetalization, of the second type used in the present invention has ethylene in a random basis as a constituent unit of a main chain. Further, the randomness of an ethylene unit in a main chain of the above-mentioned modified polyvinyl alcohol of the second type used in the present invention can be controlled by adjusting, for example, a polymerization initiator, a polymerization temperature, an addition technique of monomer and a polymerization time in copolymerization.

The above-mentioned polyvinyl alcohol mixture has an overall ethylene content of 1 to 20 mole %. When the ethylene content is less than 1 mole %, the flexibility and the heat resistance of the modified polyvinyl acetal resin of the second type used in the present invention are deteriorated, and the modified polyvinyl acetal resin has a small effect of lowering viscosity in forming a solution thereof and is low in secular stability of viscosity, and cannot adequately attain effects of improving an adhesive property, humidity resistance and a thermal decomposition property. When it is more than 20 mole %, since the water solubility of the polyvinyl alcohol mixture is lowered, an acetalization reaction becomes difficult, or the modified polyvinyl acetal resin of the second type used in the present invention to be obtained has lower solvent solubility, or lower secular stability of viscosity of a solution thereof.

Here, in this specification, the overall ethylene content (mole %) of the above-mentioned polyvinyl alcohol mixture is determined by multiplying the ethylene content of each polyvinyl alcohol composing the above-mentioned polyvinyl alcohol mixture by a weight ratio of each polyvinyl alcohol to calculate each product and summing these product. Here, an ethylene content of unmodified polyvinyl alcohol is assumed 0 mole %. For example, as for a polyvinyl alcohol mixture consisting of modified polyvinyl alcohol A and modified polyvinyl alcohol B, an overall ethylene content (mole %) is given from the following formula (1).

$$X = (A_1 \times A_2 + B_1 \times B_2) / (A_1 + B_1) \qquad (1)$$

In the formula (1), X represents an overall ethylene content of a polyvinyl alcohol mixture, $A_1$ represents weight of polyvinyl alcohol A, $A_2$ represents an ethylene content of polyvinyl alcohol A, $B_1$ represents weight of polyvinyl alcohol B, and $B_2$ represents an ethylene content of polyvinyl alcohol B.

And, though the overall ethylene content (mole %) of the modified polyvinyl acetal resin of the second type used in the present invention can also be determined by a similar method, since this ethylene content is identical to the value of a polyvinyl alcohol mixture antecedent to acetalization, in the case where the ethylene content of each of polyvinyl alcohols composing the modified polyvinyl alcohol mixture is known, the overall ethylene content of the modified polyvinyl acetal resin can be determined by using each ethylene content. And, because the polyvinyl alcohol mixture has the overall ethylene content of 1 to 20 mole %, the modified polyvinyl acetal resin of the second type used in the present invention, which is obtained by acetalizing the polyvinyl alcohol mixture, also has the overall ethylene content of 1 to 20 mole %.

The above-mentioned polyvinyl alcohol mixture has an overall saponification degree of 80 mole % or higher. When the saponification degree is lower than 80 mole %, an acetalization reaction becomes difficult since the water solubility of the polyvinyl alcohol mixture is lowered and an acetalization reaction itself becomes difficult because number of hydroxyl groups becomes less.

Here, in this specification, the overall saponification degree (mole %) of the above-mentioned polyvinyl alcohol mixture is determined by multiplying the saponification degree of each polyvinyl alcohol composing the above-mentioned polyvinyl alcohol mixture by a weight ratio of each polyvinyl alcohol to calculate each product and summing these product. For example, as for a polyvinyl alcohol mixture consisting of modified polyvinyl alcohol A and modified polyvinyl alcohol B, an overall saponification degree (mole %) is given from the following formula (2).

$$Y = (A_1 \times A_3 + B_1 \times B_3) / (A_1 + B_1) \qquad (2)$$

In the formula (2), Y represents an overall saponification degree of a polyvinyl alcohol mixture, $A_1$ represents weight of polyvinyl alcohol A, $A_3$ represents a saponification degree of polyvinyl alcohol A, $B_1$ represents weight of polyvinyl alcohol B, and $B_3$ represents a saponification degree of polyvinyl alcohol B.

And, though the overall saponification degree (mole %) of the modified polyvinyl acetal resin of the second type used in the present invention can also be determined by a similar method, since this saponification degree is identical to the value of a polyvinyl alcohol mixture antecedent to acetalization, in the case where the saponification degree of each of polyvinyl alcohols composing the modified polyvinyl alcohol mixture is known, the overall saponification degree of the modified polyvinyl acetal resin can be determined by using each saponification degree. And, because the polyvinyl alcohol mixture has the overall saponification degree of 80 mole % or higher, the modified polyvinyl acetal resin of the second type used in the present invention, which is obtained by acetalizing the polyvinyl alcohol mixture, also has the overall saponification degree of 80 mole % or higher.

The above-mentioned acetalization of the second type used in the present invention can be conducted by adding aldehyde to an aqueous solution of the above-mentioned polyvinyl alcohol mixture and following a publicly known method.

An acetalization degree of the modified polyvinyl acetal resin of the second type used in the present invention is preferably 40 to 80 mole% whether the acetalization is performed by a kind of aldehyde or by a mixture of two or more kinds of aldehydes. When the acetalization degree is less than 40 mole%, the modified polyvinyl acetal resin of the second type used in the present invention becomes soluble in water and insoluble in an organic solvent. When it is more than 80 mole%, number of residual hydroxyl groups becomes less and the toughness of the modified polyvinyl acetal resin of the second type used in the present invention may be impaired. In addition, a more favorable range may be selected for the above-mentioned acetalization degree, depending on uses of the modified polyvinyl acetal resin of the second type used in the present invention.

An polymerization degree of the modified polyvinyl acetal resin of the second type used in the present invention is not particularly limited but it is preferably 50 to 3,500. When the polymerization degree is within this range, it is possible to produce the modified polyvinyl acetal resin and the modified polyvinyl alcohol of the second type used in the present invention with high productivity. The polymerization degree is more preferably 200 to 3,500. In addition, a more favorable range may be selected for the above-mentioned polymerization degree, depending on uses of the modified polyvinyl acetal resin of the second type used in the present invention. And, in this specification, the polymerization degree of the modified polyvinyl acetal resin of the second type used in the present invention is determined by multiplying the polymerization degree of each component composing the modified polyvinyl acetal resin of the second type used in the present invention by a weight ratio of each component to calculate each product and summing these product.

A water content of the modified polyvinyl acetal resin of the second type used in the present invention is preferably 2.5 weight % or lower. As a method of reducing the above-mentioned water content to 2.5 weight % or lower, there is given a method of cleaning a product after an acetalization reaction with water or a mixed solution of water and alcohol and then reducing the water content below a specified level by drying. It is more preferably 2.0 weight % or lower.

An amount of aldehyde of the modified polyvinyl acetal resin of the second type used in the present invention is preferably 100 ppm or lower. As a method of reducing the above-mentioned amount of aldehyde to 100 ppm or lower, there is given a method of purifying a product by cleaning with water or a mixed solution of water and alcohol to reduce the amount of aldehyde below a specified level. It is more preferably 50 ppm or lower, furthermore 10 ppm or lower.

As a specific method of producing the modified polyvinyl acetal resin of the second type used in the present invention, there are given, for example, a method of dissolving the polyvinyl alcohol mixture in a solvent, reacting the solution with a predetermined amount of aldehydes so as to provide the modified polyvinyl acetal resin with a desired acetalization degree in the presence of an acid catalyst, terminating an acetalization reaction with an alkali or a terminator, and then water washing and drying a product.

The modified polyvinyl acetal resin of the second type used in the present invention is formed by acetalizing a mixture of polyvinyl alcohols having ethylene in a random basis as a constituent unit of a main chain and having a predetermined ethylene content and a predetermined saponification degree, and since the hydrogen bond strength of a hydroxyl group contained in the modified polyvinyl acetal resin is weakened, a solution of the modified polyvinyl acetal resin has low viscosity and high secular stability of viscosity and can form a coat with high flexibility. Such the modified polyvinyl acetal resin of the second type used in the present invention can be effectively used in application areas such as ceramics.

The present invention is a slurry composition for a ceramic green sheet, which contains the modified vinyl acetal resin of the first type used in the present invention or the second type used in the present invention, ceramic powder, a plasticizer and an organic solvent.

An acetalization degree of the modified polyvinyl acetal resin of the first type used in the present invention or the second present invention in the case of being used in the slurry composition for a ceramic green sheet of the present invention is more preferably 40 to 79 mole% whether the acetalization is performed by a kind of aldehyde or by a mixture of two or more kinds of aldehydes. When the acetalization degree is less than 40 mole%, the modified polyvinyl acetal resin of the first type used in the present invention or the second type used in the present invention becomes soluble in water and insoluble in an organic solvent. When it is more than 79 mole%, number of residual hydroxyl groups becomes less and the toughness of the modified polyvinyl acetal resin of the first type used in the present invention or the second type used in the present invention may be impaired and the strength of the ceramic green sheet may be deteriorated.

An polymerization degree of the modified polyvinyl acetal resin of the first type used in the present invention or the second type used in the present invention in the case of being used in the slurry composition for a ceramic green sheet of the present invention is not particularly limited but it is more preferably 300 to 2,400. When the polymerization degree is less than 300, the strength of a ceramic green sheet formed from a slurry composition is low and the ceramic green sheet is apt to generate breaks and cracks in being released from a supporting member, and when it is more than 2,400, since the solution viscosity of the slurry becomes too high, the slurry is poor in dispersibility and homogeneous slurry cannot be attained.

An amount of the modified polyvinyl acetal resin of the first type used in the present invention or the second type used in the present invention to be blended is preferably 3 to 15 weight % with respect to the total amount of the slurry composition for a ceramic green sheet of the present invention. When the amount of the modified polyvinyl acetal resin to be blended is less than 3 weight %, because an amount of the modified polyvinyl acetal resin of the first type used in the present invention or the second type used in the present invention dispersed throughout ceramic powder is insufficient, flexibility of the ceramic green sheet to be obtained is insufficient and cracks may occur after sintering. When it is more than 15 weight %, the slurry composition for a ceramic green sheet of the present invention becomes too high in viscosity and therefore the dispersibility thereof is deteriorated, or shrinkage of the sheet becomes large in sintering the obtained ceramic green sheet.

The above-mentioned ceramic powder is not particularly limited and ceramic powder conventionally used for producing a ceramic green sheet is given. As such ceramic powder, there is given powder composed of, for example, alumina, zirconia, aluminum silicate, titanium oxide, zinc oxide, barium titanate, magnesia, sialon, spinel mullite, crystallized glass, silicon carbide, silicon nitride, aluminum nitride or the like. These ceramic powders may be used alone or in combination of two or more species.

And glass frit such as MgO-SiO$_2$-CaO system, B$_2$O$_3$-SiO$_2$ system, PbO-B$_2$O$_3$-SiO$_2$ system, CaO-SiO$_2$-MgO-B$_2$O$_3$ system or PbO-SiO$_2$-B$_2$O$_3$-CaO system may be added to these ceramic powders.

A particle size of the above-mentioned ceramic powder is preferably fine, and ceramic powder having a particularly fine particle size is preferably used for attaining a thin ceramic green sheet. For example, it is preferred that the above-mentioned ceramic powder has a particle size of 0.3 $\mu$m or smaller in order to attain a ceramic green sheet of 3 $\mu$m or less in thickness.

An amount of the above-mentioned ceramic powder to be blended is preferably 30 to 80 weight % with respect to the total amount of the slurry composition for a ceramic green sheet of the present invention. When the amount to be blended is less than 30 weight %, handling in forming the ceramic green sheet may deteriorate since the viscosity of the slurry composition for a ceramic green sheet of the present invention becomes too low. When it is more than 80 weight %, a kneading property may be deteriorated since the viscosity of the slurry composition for a ceramic green sheet of the present invention becomes too high.

The above-mentioned plasticizer is not particularly limited, and any plasticizer can be employed as long as it is high in compatibility with the modified polyvinyl acetal resin of the first type used in the present invention or the second type used in the present invention. As the plasticizer, there are given phthalates such as dibutyl phthalate, dioctyl phthalate, diisodecyl phthalate, butyl benzyl phthalate, etc.; phosphates such as tricresylphosphate, tributyl phosphate, triethyl phosphate, etc.; fatty acid esters such as methylacetyl ricinoleate, dibutyl sebacate and dioctyl adipate, etc.; glycol derivatives such as butylphthalyl glycolate, triethylene glycol-2-ethyl butylate, etc. These plasticizers may be used alone or in combination of two or more species.

An amount of the above plasticizer to be blended is preferably 0.1 to 10 weight % with respect to the total amount of the slurry composition for a ceramic green sheet of the present invention. When the amount to be blended is less than 0.1 weight %, the flexibility of the ceramic green sheet, which is obtained by blending the plasticizer, will be insufficient. When it is more than 10 weight %, handling in forming the ceramic green sheet may be deteriorated since the ceramic green sheet becomes too flexible.

The above-mentioned organic solvent is not particularly limited and ketones such as acetone, methyl ethyl ketone, etc.; alcohols such as methanol, ethanol, isopropanol, n-propanol, n-butanol, etc.; and aromatic hydrocarbons such as toluene, xylene, etc. are given. These solvents may be used alone or in combination of two or more species.

An amount of the above-mentioned solvent to be blended is preferably 20 to 80 weight % with respect to the total amount of the slurry composition for a ceramic green sheet of the present invention. When the amount to be blended falls within this range, it is possible to dissolve the modified polyvinyl acetal resin of the first type used in the or the second type used in the present invention and to provides the slurry composition for a ceramic green sheet of the present invention with an adequate kneading property.

The slurry composition for a ceramic green sheet of the present invention may include a lubricant, a dispersant, a deflocculant, a wetting agent, an antistatic agent, an antifoaming agent, etc. as required within the bounds of being able to attain an object of the present invention.

The slurry composition for a ceramic green sheet of the present invention can be prepared by blending the modified polyvinyl acetal resin of the first type used in the present invention or the second type used in the present invention, a ceramic powder, a plasticizer and an organic solvent and mixing them by an ordinary technique.

The ceramic green sheet can be obtained by configuring the slurry composition for a ceramic green sheet of the present invention in sheet form and drying it. For example, after the slurry composition for a ceramic green sheet of the present invention is deaerated as required, it is applied onto the surface of a supporting member such as a polyester film or a stainless steel plate from which the ceramic green sheet is removable, and after removing an organic solvent by heating and drying, it is released from the supporting member. Such a ceramic green sheet formed by using the slurry composition for a ceramic green sheet of the present invention is also one of the present inventions.

By using the ceramic green sheet of the present invention, a laminated ceramic condenser can be attained. It is possible to obtain the above-mentioned laminated ceramic condenser by superposing two or more sheets of processed ceramic green sheets which is formed by applying a conductive paste to become an internal electrode by screen process printing onto the ceramic green sheet of the present invention, thermally attaching the processed ceramic green sheet to another by pressure to prepare a laminate, cutting the laminate to the predetermined shape and dimensions, and then heating the cut laminate to elevated temperatures of, for example, about 600°C to decompose the polyvinyl acetal resin, used as a binder resin, of the first type used in the present invention or the second type used in the present invention thoroughly, and further heating it to elevated temperatures of, for example, about 1350°C to sinter the ceramic powder and subsequently sintering an external electrode on the side of the resulting ceramic sintered body.

The slurry composition for a ceramic green sheet of the present invention contains the polyvinyl acetal resin of the first type used in the present invention or the second type used in the present invention as a binder resin and since the hydrogen bond strength of the modified polyvinyl acetal resin is weakened in terms of steric hindrance, it has low viscosity and excellent secular stability of viscosity compare with the case where only a unmodified polyvinyl acetal resin is used as a binder resin. This allows the slurry composition to become higher solid contents by reducing an amount of a solvent to be used and also the slurry to be stored for long periods.

The ceramic green sheet of the present invention substantially improves in sheet strength, particularly ductility, since the slurry composition for a ceramic green sheet of the present invention need not contain a plasticizer excessively, and has a good balanced adhesive property in lamination in which the ceramic green sheet is easy to be released from a supporting member and has a high adhesive property in being attached to another by pressure. Because the ceramic green sheet of the present invention has low moisture absorption, it can be stored in a state of a ceramic green sheet for long periods and is less subject to moisture when it is subjected to process such as punching. Therefore, it can be formed without being affected by moisture and laminated without being damaged even when it is a thin layer ceramic green sheet having a thickness of 3 $\mu$m or smaller. Further, in the ceramic green sheet of the present invention, since the contained polyvinyl acetal resin of the first type used in the present invention or the second type used in the present invention is excellent in a thermal decomposition property and very low in a thermal decomposition residue, it does not produce the thermal decomposition residue of the binder in the ceramic green sheet after sintering even when a laminate, formed by superposing a thin layer ceramic green sheet having a thickness of 3 $\mu$m or smaller by 500 sheets or more, is sintered and therefore it can attain a laminate superior in electrical characteristics. Accordingly, it is possible to respond to downsizing of electronic devices such as a laminated ceramic condenser and also to respond to LTCC (low temperature cofired ceramic substrate) which requires a debinder property at low temperature such as uses of glass powder and uses of copper in an electrode. And, since the modified polyvinyl acetal resin of the first type used in the present invention or the second type used in the present invention contains ethylene units as a monomer unit, the ceramic green sheet of the present invention improves in compatibility with a plasticizer remarkably and therefore suppresses bleeding of the plasticizer and allows the ceramic green sheet to be stored for long periods, and further since it shows a small shrinkage rate in sintering, it improves in dimensional stability and can respond to downsizing of electronic devices.

BEST MODE FOR CARRYING OUT THE INVENTION

Hereinafter, the present invention will be described in more detail by way of examples, but the present invention is not limited to these examples.

(Example 28) (not according to the invention)

<Preparation of modified polyvinyl acetal resin>

193 g of modified polyvinyl alcohol, which has a polymerization degree of 500, an ethylene content of 5 mole % and a saponification degree of 98 mole %, having ethylene in a random basis as a constituent unit of a main chain was added to 2,900 g of distilled water and the mixture was stirred at a temperature of 90˚C for about 2 hours and dissolved. This solution was cooled to 28˚C and 20 g of 35 weight % hydrochloric acid and 125 g of n-butyl aldehyde were added to the solution and a temperature of the mixture was lowered to 20˚C and kept at this temperature to acetalize it and precipitate a reaction product. Then, a liquid temperature was kept at 30˚C for 5 hours to complete an acetalization reaction. The mixture of a reaction product was washed with distilled water and sodium hydrogencarbonate was added to the washed modified polyvinyl acetal resin dispersion to adjust the solution to a pH of 8. Next, the solution was kept at 60˚C for 5 hours, and then cooled and washed with distilled water a hundred times as much as a solid matter. Further, after the solution was kept at 50˚C for 5 hours, it was washed with distilled water a hundred times as much as a solid matter, dehydrated and then dried.

The resulting modified polyvinyl acetal resin was dissolved in DMSO-d$_6$ and a degree of acetalization was measured using $^{13}$C-NMR spectrometer to obtain the acetalization degree of 75 mole %. And, the amounts of remaining aldehyde and remaining water were 10 ppm and 2.0 weight %, respectively. It could be verified that the modified polyvinyl acetal resin had ethylene in a random basis as a constituent unit of a main chain because only one glass transition temperature appeared when the glass transition temperature of the resulting polyvinyl acetal resin was measured with a differential scanning calorimeter and the modified polyvinyl acetal resin was dissolved thoroughly in a mixed solution of ethanol and toluene having a weight ratio of 1:1 and in methyl ethyl ketone. Incidentally, the above-mentioned amount of remaining aldehyde was measured by thermally extracting the modified polyvinyl acetal resin in a heating furnace and measuring an extract using a gas chromatography. The above-mentioned amount of remaining water was measured using a Karl Fischer moisture meter.

<Preparation of coating solution for thermal developing photosensitive material film>

5.0 g of the above-mentioned modified polyvinyl acetal resin, 5.0 g of silver behenate and 40 g of methyl ethyl ketone were mixed with a ball mill for 24 hours, and further 0.2 g of N-lauryl-1-hydroxy-2-naphthamide was added to the mixture and this mixture was again milled by the ball mill to obtain a coating solution.

< Preparation of thermal developing photosensitive material film>

The above-mentioned coating solution was applied to a polyester substrate so as to be 10 μm in thickness after drying and dried. A solution consisting of 0.5 g of lead N,N-dimethyl-p-phenylenediamine sulfate, 2 g of polyvinylpyrrolidone and 30 ml of methanol was applied to this coated surface so as to be 1 μm in thickness after drying and dried. A thermal developing photosensitive material film was prepared by laminating thus.

(Examples 29 to 34, Comparative Examples 25 to 28) (not according to the invention)

Thermal developing photosensitive material films were prepared by following the same procedure as Example 28 except for changing a polymerization degree, a saponification degree, a kind of aldehyde, an acetalization degree, an amount of remaining water and an amount of remaining aldehyde of modified polyvinyl alcohol as shown in Table 8. It could be verified that the modified polyvinyl acetal resins, obtained in Examples 29 to 34, had ethylene in a random basis as a constituent unit of a main chain because only one glass transition temperature, which corresponded to one kind of modified polyvinyl acetal contained, appeared when the glass transition temperature of modified polyvinyl acetal resin was measured with a differential scanning calorimeter and the modified polyvinyl acetal resin was dissolved thoroughly in a mixed solution of ethanol and toluene having a weight ratio of 1:1 and in methyl ethyl ketone.

<Performance evaluations>

Performances of the thermal developing photosensitive material films obtained in Examples 28 to 34 and Comparative Examples 25 to 28 were evaluated according to the following methods. The results of evaluations were shown in Table 8.

(Storage stability of raw film)

The thermal developing photosensitive material film was stored in conditions of 20°C and 90 % humidity for 1 month. Then, the photosensitive film was exposed through a tone pattern film to light from a high-voltage mercury lamp of 250 W at a distance of 20 cm for 0.3 second and heated for 3 seconds with a hot plate of 110°C to obtain a pattern image having a cyan color. The resulting film was rated on the following scale of 3 levels.

○: there was no fog and sharpness was good
Δ: there were a few fogs and sharpness was not so good.
×: there were many fogs and sharpness was poor.

(Blocking property of raw film)

The thermal developing photosensitive material film was cut in sheets of a A4-size, and each sheet was superposed on another up to 100 sheets and stored in conditions of 4.0°C and 90 % humidity for 1 month. The level of blocking of the films in that time was rated on the following scale of 3 levels.

○: there was no blocking and each sheet was released neatly.
Δ: blocking occurred in a part of film sheets and some parts were difficult to be released.
×: blocking occurred in most of film sheets and it was considerably difficult to release them.

(Storage stability of film after forming image)

The photosensitive film was exposed through a tone pattern film to light from a high-voltage mercury lamp of 250 W at a distance of 20 cm for 0.3 second and then heated for 3 seconds with a hot plate of 110°C to obtain a pattern image having a cyan color. Then, the film was stored in conditions of 40°C and 90 % humidity for 1 month. The surface condition of the film in that time was rated on the following scale of 3 levels.
○: the image which had been formed before storage was retained.

$\Delta$: a part of the image changed and became white after storage.

$\times$: appreciable part of the image changed and became white after storage.

Table 8

| | | Polyvinyl alcohol | | | | Polyvinyl acetal resin | | | Results of performance evaluation | | |
|---|---|---|---|---|---|---|---|---|---|---|---|
| | | Polymerization degree | Ethylene content (mole %) | Saponification degree (mole %) | PVA blending ratio | Aldehyde (acetalization degree:mole %) | Amount of aldehyde (ppm) | Amount of water content (%) | Storage stability of raw film | Blocking property of raw film | Storage stability of film after forming image |
| Example | 28 | 500 | 5 | 98 | - | n-butyl aldehyde(75) | 10 | 2.0 | ○ | ○ | ○ |
| | 29 | 800 | 10 | 95 | - | n-butyl aldehyde(72) | 25 | 1.5 | ○ | ○ | ○ |
| | 30 | 800 | 5 | 88 | - | n-butyl aldehyde(66) | 10 | 2.0 | ○ | ○ | ○ |
| | 31 | 500 | 10 | 98 | - | n-butyl aldehyde(34) Acetaldehyde (37) | 5 | 1.5 | ○ | ○ | ○ |
| | 32 | 800 800 | 5 0 | 88 88 | 1/1 Weight ratio | n-butyl aldehyde(63) | 8 | 1.5 | ○ | ○ | ○ |
| | 33 | 500 800 | 5 0 | 98 98 | 1/1 Weight ratio | Acetaldehyde (73) | 3 | 2.0 | ○ | ○ | ○ |
| | 34 | 500 800 | 5 0 | 98 88 | 1/1 Weight ratio | n-butyl aldehyde (30) Acetaldehyde (36) | 3 | 1.5 | ○ | ○ | ○ |

13

EP 1 429 400 B1

| | | Polyvinyl alcohol | | | | Polyvinyl acetal resin | | | Results of performance evaluation | | |
|---|---|---|---|---|---|---|---|---|---|---|---|
| | | Polymerization degree | Ethylene content (mole %) | Saponification degree (mole %) | PVA blending ratio | Aldehyde (acetalization degree:mole %) | Amount of aldehyde (ppm) | Amount of water content (%) | Storage stability of raw film | Blocking property of raw film | Storage stability of film after forming image |
| Comparative Example | 25 | 500 | 0 | 98 | - | n-butyl aldehyde (60) | 3 | 3. 5 | × | × | × |
| | 26 | 800 | 0 | 98 | - | Acetaldehyde (62) | 3 | 5. 0 | × | × | × |
| | 27 | 500 | 0 | 98 | - | n-butyl aldehyde(25) Acetaldehyde (30) | 3 | 6.5 | × | × | × |
| | 28 | 500 800 | 0 0 | 98 98 | 1/1 Weight ratio | n-butyl aldehyde (58) | 3 | 4.5 | × | × | × |

EP 1 429 400 B1

The results of Table 8 show that the thermal developing photosensitive material films obtained in Examples 28 to 34 were superior in the storage stability of a raw film, the blocking property of a raw film and the storage stability of film after forming images compared with the thermal developing photosensitive material films obtained in Comparative Examples 25 to 28.

(Example 35)

<Preparation of modified polyvinyl acetal resin>

193 g of modified polyvinyl alcohol, which has a polymerization degree of 800, an ethylene content of 5 mole % and a saponification degree of 93 mole %, having ethylene in a random basis as a constituent unit of a main chain was added to 2,900 g of pure water and the mixture was stirred at a temperature of 90°C for about 2 hours and dissolved. This solution was cooled to 28°C and 20 g of 35 weight % hydrochloric acid and 115 g of n-butyl aldehyde were added to the solution and a temperature of the mixture was lowered to 20°C and kept at this temperature to acetalize it and precipitate a reaction product. Then, a liquid temperature was kept at 30°C for 5 hours to complete an acetalization reaction. The mixture of a reaction product was neutralized, water-washed and dried by a normal method to obtain white powder of a modified polyvinyl acetal resin having ethylene in a random basis as a constituent unit of a main chain.

The resulting modified polyvinyl acetal resin was dissolved in DMSO-$d_6$ and a degree of acetalization was measured using $^{13}$C-NMR spectrometer to obtain the acetalization degree of 68 mole %. And, it could be verified that the modified polyvinyl acetal resin had ethylene in a random basis as a constituent unit of a main chain because only one glass transition temperature appeared when the glass transition temperature was measured with a differential scanning calorimeter and the modified polyvinyl acetal resin was dissolved thoroughly in a mixed solution of ethanol and toluene having a weight ratio of 1:1 and in methyl ethyl ketone.

<Preparation of a slurry composition for a ceramic green sheet>

10 parts by weight of the above-mentioned modified polyvinyl acetal resin was added to a mixed solvent of 30 parts by weight of toluene and 15 parts by weight of ethanol, stirred and dissolved. To this resin solution, 3 parts by weight of dibutyl phthalate was added as a plasticizer, stirred and dissolved. 100 parts by weight of barium titanate powder, having a mean particle diameter of 0.3 $\mu$m, was added to the resin solution thus obtained as ceramic powder. This mixture was mixed for 36 hours with a ball mill and a slurry composition for a ceramic green sheet, in which the barium titanate powder was dispersed, was obtained.

<Preparation of ceramic green sheet>

The above-mentioned slurry composition for a ceramic green sheet was applied to the polyester film, which had been treated for releasing, in a thickness of 6 $\mu$m and dried with winds at room temperature for 30 minutes and further dried at 60 to 80°C for 15 hours with a hot air dryer to dry an organic solvent and a ceramic green sheet of a thin layer having a thickness of 3 $\mu$m was obtained.

(Examples 36 to 41)

By following the same procedure as Example 34 except for changing a polymerization degree, an ethylene content, a saponification degree, a kind of aldehyde, an acetalization degree, a mean particle diameter of ceramic powder and a plasticizer of polyvinyl alcohol as shown in Table 9, modified polyvinyl acetal resins, having ethylene in a random basis as a constituent unit of a main chain, were prepared, and slurry compositions and ceramic green sheets were prepared. In addition, in Examples 39 to 41, a mixture of modified polyvinyl alcohol and unmodified polyvinyl alcohol having a weight ratio of 1:1 was used in preparation of the modified polyvinyl acetal resin. It could be verified that the modified polyvinyl acetal resins, obtained in Examples 36 to 41, had ethylene in a random basis as a constituent unit of a main chain because only one glass transition temperature, which corresponded to one kind of modified polyvinyl acetal contained, appeared when the glass transition temperature of modified polyvinyl acetal resin was measured with a differential scanning calorimeter and the modified polyvinyl acetal resin was dissolved thoroughly in a mixed solution of ethanol and toluene having a weight ratio of 1 : 1 and in methyl ethyl ketone.

(Comparative Examples 29 to 35)

By following the same procedures as corresponding Examples 35 to 41 except for using unmodified polyvinyl alcohol having the same structure as modified polyvinyl alcohol used in Examples 35 to 41 other than not containing ethylene as a monomer unit, polyvinyl acetal resins having the same acetalization degree as corresponding Examples 35 to 41 were prepared and slurry compositions and ceramic green sheets were prepared using these polyvinyl acetal resins.

<Performance evaluations>

The viscosity and the viscosity stability of the slurry compositions, and the releasability, the adhesive property and the ductility of the ceramic green sheets, which were obtained in Examples 35 to 41 and Comparative Examples 29 to 35, were evaluated according to the following methods and the results of evaluations were shown in Tables 9 and 10. The moisture absorption of the ceramic green sheets and the amounts of the thermal decomposition residue after sintering of the ceramic green sheets, which were obtained in Examples 35 to 41 and Comparative Examples 29 to 35, were evaluated according to the following methods and the results were shown in Tables 11.

(Viscosity of slurry composition and difference in viscosity)

The viscosities of the slurry compositions obtained in Examples 35 to 41 and Comparative Examples 29 to 35 were measured at 20˚C using a Brookfield type rotational viscometer and these viscosities were taken as initial viscosities.
Next, the viscosity of the slurry composition obtained in Example 35 was compared with the viscosity of the slurry composition obtained in Comparative Example 29 corresponding to Example 35, and (a rate of) a difference in viscosity was determined from the following formula (6).

$$\text{Difference in viscosity (\%)} = (G - H) / H \times 100 \quad (6)$$

In the formula (6), G represents the viscosity of the slurry composition (Example 35) made from the modified polyvinyl acetal resin and H represents the viscosity of the slurry composition (Comparative Example 29) made from the unmodified polyvinyl acetal resin.
Similarly, the viscosities of the slurry compositions obtained in Examples 36 to 41 were compared with the viscosities of the slurry compositions obtained in Comparative Examples 30 to 35 corresponding to Examples 36 to 41, respectively, and a difference in viscosity was determined.

(Secular stability of slurry viscosity (rate of change of viscosity))

The slurry solution of which the above-mentioned initial viscosity was measured was stored for 1 month in a thermostatic chamber kept at 20˚C, and the viscosity after the storage was measured at 20˚C using a Brookfield type rotational viscometer, and a rate of change of viscosity was determined from the following formula (7).

$$\text{Rate of change of viscosity (\%)} = (I - J) / J \times 100 \quad (7)$$

In the formula (7), I represents the viscosity of 1 month later and J represents the initial viscosity.

(Releasability of a ceramic green sheet)

Each of the ceramic green sheets obtained in Examples 35 to 41 and Comparative Examples 29 to 35 was cut in sheets of a size of 10 cm $\times$ 10 cm, and each sheet was superposed on another up to 10 sheets on a PET film and laminated under conditions of being thermally attached to another by pressure of 1,500 N/cm$^2$ at 70˚C for 10 minutes, and then the state in releasing the ceramic green sheets from the PET film was rated on the following scale of 3 levels through a sensory analysis based on visual observations.

○: there was no ceramic green sheet adhered to the PET film and there was no break nor crack of the ceramic green sheet.

Δ: there was a part of ceramic green sheets adhered to the PET film and there were breaks and cracks of the ceramic green sheet in part.

×: there were many parts of ceramic green sheets adhered to the PET film and there were many breaks and cracks of the ceramic green sheet.

(Adhesive property of a ceramic green sheet)

Each of the ceramic green sheets obtained in Examples 35 to 41 and Comparative Examples 29 to 35 was cut in sheets of a size of 10 cm × 10 cm, and each sheet was superposed on another up to 200 sheets and laminated under conditions of being thermally attached to another by pressure of 1,500 N/cm$^2$ at 70˚C for 10 minutes, and then the adhesive property between the respective ceramic green sheet layers was rated on the following scale of 3 levels through a sensory analysis based on visual observations.

○: there was no delamination and the respective ceramic green sheet layers adhered to one another.

Δ: there were delaminations in part.

×: there were considerable delaminations

(Ductility of a sheet and difference in ductility)

The ceramic green sheets obtained in Examples 35 to 41 and Comparative Examples 29 to 35 were stretched at a stretch speed of 10 mm/minute at 20˚C and a ductility of a maximum point was measured using Autograph (manufactured by SHIMADZU CORPORATION).

Next, the ductility of a maximum point of the ceramic green sheet obtained in Example 35 was compared with the ductility of a maximum point of the ceramic green sheet obtained in Comparative Example 29 corresponding to Example 35, and (a rate of) a difference in ductility was determined from the following formula (8).

$$\text{Difference in ductility (\%)} = (K - L) / F \times 100 \quad (8)$$

In the formula (8), K represents the ductility of a maximum point of the ceramic green sheet (Example 35) made from the modified polyvinyl acetal resin and L represents the ductility of a maximum point of the ceramic green sheet (Comparative Example 29) made from the unmodified polyvinyl acetal resin.

Similarly, the ductilities of a maximum point of the ceramic green sheets obtained in Examples 36 to 41 were compared with the ductilities of a maximum point of the ceramic green sheet obtained in Comparative Examples 30 to 35 corresponding to Examples 36 to 41, respectively, and (a rate of) a difference in ductility was determined.

Table 9

| | | Polyvinyl alcohol | | | | Polyvinyl acetal resin | Ceramic | Plasticizer | Results of performance evaluation | | | | |
|---|---|---|---|---|---|---|---|---|---|---|---|---|---|
| | | | | | | | | | Slurry | | Ceramic green sheet | | |
| | | Polymerization degree | Ethylene content (more %) | Saponification degree (mole %) | PVA blending ratio | Aldehyde (acetalization degree:mole %) | Kind (mean particle diameter ; μm) | Kind | Difference in viscosity (%) | Rate of change of viscosity (%) | Releasability | Adhesive property | Difference in ductility (%) |
| Example | 35 | 800 | 5 | 93 | - | n-butyl aldehyde (68) | Barium titanate (0. 3) | Dibutyl phthalate | -57 | +4 | ○ | ○ | +95 |
| | 36 | 800 | 10 | 88 | - | n-butyl aldehyde (60) | Barium titanate (0. 3) | Dibutyl phthalate | -53 | +7 | ○ | ○ | +88 |
| | 37 | 800 | 5 | 93 | - | n-butyl aldehyde (28) Acetaldehyde (34) | Barium titanate (0. 3) | Dibutyl octanol | -54 | +9 | ○ | ○ | +82 |
| | 38 | 1700 | 10 | 88 | - | Acetaldehyde (65) | Barium titanate (0. 3) | Dibutyl octanol | -56 | +11 | ○ | ○ | +73 |
| | 39 | 600 / 600 | 5 / 0 | 93 / 98 | 1/1 Weight ratio | n-butyl aldehyde (68) | Barium titanate (0. 3) | Dibutyl octanol | -59 | +6 | ○ | ○ | +85 |
| | 40 | 600 / 600 | 5 / 0 | 93 / 98 | 1/1 Weight ratio | n-butyl aldehyde (30) Acetaldehyde (36) | Barium titanate (0. 3) | Dibutyl phthalate | -55 | +8 | ○ | ○ | -78 |
| | 41 | 600 / 600 | 5 / 0 | 93 / 98 | 1/1 Weight ratio | Aceteldehyde Acetaldehyde (70) | Barium titanate (0. 3) | Dibutyl phthalate | -52 | +13 | ○ | ○ | +71 |

Table 10

| | | Polyvinyl alcohol | | | | Polyvinyl acetal resin | Ceramic | Plasticizer | Results of performance evaluation | | |
| | | | | | | | | | Slurry | Ceramic green sheet | |
| | | Polymerization degree | Ethylene content (mole %) | Saponification degree (mole %) | PVA blending ratio | Aldehyde (acetalization degree:mole %) | Kind (mean particle diameter ; μm) | Kind | Rate of change of viscosity (%) | Releasability | Adhesive property |
|---|---|---|---|---|---|---|---|---|---|---|---|
| Comparative Example | 29 | 800 | 0 | 93 | - | n-butyl aldehyde (68) | Barium titanate (0.3) | Dibutyl phthalate | +40 | ○ | Δ |
| | 30 | 800 | 0 | 88 | - | n-butyl aldehyde (60) | Barium titanate (0.3) | Dibutyl phthalate | +53 | ○ | Δ |
| | 31 | 800 | 0 | 93 | - | n-butyl aldehyde (28) Acetaldehyde (34) | Barium titanate (0.3) | Dibutyl octanol | +68 | Δ | × |
| | 32 | 1700 | 0 | 88 | - | Acetaldehyde (65) | Barium titanate (0.3) | Dibutyl octanol | +82 | Δ | × |
| | 33 | 600 600 | 0 | 93 98 | 1/1 Weight ratio | n-butyl aldehyde (68) | Barium titanate (0.3) | Dibutyl octanol | +44 | ○ | Δ |
| | 34 | 600 600 | 0 | 93 98 | 1/1 Weight ratio | n-butyl aldehyde (30) Acetaldehyde (36) | Barium titanate (0.3) | Dibutyl phthalate | +72 | Δ | × |
| | 35 | 600 600 | 0 | 93 98 | 1/1 Weight ratio | Acetaldehyde (70) | Barium titanate (0.3) | Dibutyl phthalate | +93 | Δ | × |

The results of Tables 9 and 10 show that the slurry compositions obtained in Examples 35 to 41 were significantly low in the slurry viscosity and very stable in the secular stability of the slurry viscosity compared with the ceramic green sheets obtained in Comparative Examples 29 to 35.

And, the ceramic green sheets obtained in Examples 35 to 41 were excellent in the releasability and the adhesive property. On the other hand, the ceramic green sheets obtained in Comparative Examples 31, 32, 34 and 35 were hard and developed cracks in being released, and were found to delaminate in fair parts between sheet layers.

Also, the ceramic green sheets obtained in Examples 35 to 41 stretch well and were excellent in the flexibility compared with the ceramic green sheets obtained in Comparative Examples 29 to 35.

(Moisture absorption of green sheet)

The ceramic green sheets obtained in Examples 35 to 41 and Comparative Examples 29 to 35 were cut in sheets of a size of 10 cm × 10 cm, and these sheets were left alone in conditions of 20˚C and 90 % humidity for 5 days and weighed before and after the duration of being left alone. The moisture absorption of a green sheet was determined from a change in weight during the duration of being left alone using the following formula (9).

$$\text{Moisture absorption (\%)} = (M - N) / N \times 100 \qquad (9)$$

In the formula (9), M represents the weight of the ceramic green sheet after the duration of being left alone and N represents the weight of the ceramic green sheet measured before the duration.

(Thermal decomposition residue of modified polyvinyl acetal resin)

10 mg of the modified polyvinyl acetal resins obtained in Examples 35 to 41 and Comparative Examples 29 to 35 was heated at a rate of a temperature rise of 10˚C/minute from room temperature to 700˚C in a nitrogen atmosphere, and then an amount of thermal decomposition residue was determined.

(Thermal decomposition residue of ceramic green sheet)

Each of the ceramic green sheets obtained in Examples 35 to 41 and Comparative Examples 29 to 35 was cut in sheets of a size of 10 cm×10 cm, and each sheet was superposed on another up to 500 sheets and laminated under conditions of being thermally attached to another by pressure of 1,500 N/cm$^2$ at 70˚C for 10 minutes to obtain a laminate of a ceramic green sheet. Next, this ceramic green sheet laminate was heated at a rate of a temperature rise of 3˚C/minute to 450˚C in a nitrogen atmosphere and kept at this temperature for 5 hours, and then heated at a rate of a temperature rise of 5˚C/minute to 1,350˚C and kept at this temperature for 10 hours to sinter the ceramic completely. This sintered ceramic green sheet was cooled to room temperature and then the ceramic green sheet was divided into two halves and the state of the face of the divided ceramic green sheet, which was just located near the 250th layer, was observed with an electron microscope and rated on the following scale of 3 levels.

○: the sheet was sintered uniformly and there was nothing other than ceramic powder.

Δ: black spot was rarely found in part in the ceramic green sheet.

×: fairly many black spots were found in the ceramic green sheet.

Table 11

| | | Polyvinyl alcohol | | | | Polyvinyl acetal resin | Ceramic | Plasticizer | Results of performance evaluation | | |
|---|---|---|---|---|---|---|---|---|---|---|---|
| | | Polymerization content degree | Ethylene content (mole %) | Saponification degree (mole %) | PVA blending ratio | Aldehyde (acetalization degree:mole %) | Kind (mean particle diameter; $\mu$m) | Kind | Moisture absorption of ceramic green sheet (%) | Thermal decomposition residue of resin (%) | Thermal decomposition residue of ceramic green sheet |
| Example | 35 | 800 | 5 | 93 | - | n-butyl aldehyde(68) | | | 0. 18 | 0. 1 | ○ |
| | 36 | 800 | 10 | 88 | - | n-butyl aldehyde (60) | Barium titanate (0.3) | Dibutyl phthalate | 0.22 | 0.05 | ○ |
| | 37 | 800 | 5 | 93 | - | n-butyl aldehyde (28) Acetaldehyde (34) | Barium titanate (0. 3) | Dibutyl octanol | 0.25 | 0.08 | ○ |
| | 38 | 1700 | 10 | 88 | - | Acetaldehyde (65) | Barium titanate (0.3) | Dibutyl octanol | 0.28 | 0.03 | ○ |
| | 39 | 600 600 | 5 0 | 93 98 | 1/1 Weight ratio | n-butyl aldehyde (68) | Barium titanate (0.3) | Dibutyl octanol | 0.17 | 0.1 | ○ |
| | 40 | 600 600 | 5 0 | 93 98 | 1/1 Weight ratio | n-butyl aldehyde (30) Acetaldehyde (36) | Barium titanate (0.3) | Dibutyl phthalate | 0.24 | 0.1 | ○ |
| | 41 | 600 600 | 5 0 | 93 98 | 1/1 Weight ratio | Acetaldehyde (70) | Barium titanate (0.3) | Dibutyl phthalate | 0.27 | 0.09 | ○ |

EP 1 429 400 B1

(continued)

| | | Polyvinyl alcohol | | | | Polyvinyl acetal resin | Ceramic | Plasticizer | Results of performance evaluation | | |
|---|---|---|---|---|---|---|---|---|---|---|---|
| | | Polymerization content degree | Ethylene content (mole %) | Saponification degree (mole %) | PVA blending ratio | Aldehyde (acetalization degree:mole %) | Kind (mean particle diameter; $\mu m$) | Kind | Moisture absorption of ceramic green sheet (%) | Thermal decomposition residue of resin (%) | Thermal decomposition residue of ceramic green sheet |
| Comparative Example | 29 | 800 | 0 | 93 | - | n-butyl aldehyde (68) | Barium titanate (0.3) | Dibutyl phthalate | 0.43 | 2.8 | × |
| | 30 | 800 | 0 | 88 | - | n-butyl aldehyde (60) | Barium titanate (0.3) | Dibutyl phthalate | 0.45 | 2.7 | × |
| | 31 | 800 | 0 | 93 | - | n-butyl aldehyde(28) Acetaldehyde (34) | Barium titanate (0.3) | Dibutyl octanol | 0.47 | 2.4 | × |
| | 32 | 1700 | 0 | 88 | - | Acetaldehyde (65) | Barium titanate (0.3) | Dibutyl octanol | 0. 51 | 2.8 | × |
| | 33 | 600 600 | 0 | 93 98 | 1/1 Weight ratio | n-but aldehyde (68) | Barium titanate (0.3) | Dibutyl octanol | 0.44 | 2.4 | × |
| | 34 | 600 600 | 0 | 93 98 | 1/1 Weight ratio | n-butyl aldehyde(30) Acetaldehyde (36) | Barium titanate (0.3) | Dibutyl phthalate | 0.48 | 2.9 | × |
| | 35 | 600 600 | 0 | 93 98 | 1/1 Weight ratio | Acetaldehyde (70) | Barium titanate (0.3) | Dibutyl phthalate | 0.52 | 2.6 | × |

The results of Table 11 show that the ceramic green sheets obtained in Examples 35 to 41 were significantly low in the moisture absorption, significantly less in the thermal decomposition residue of the modified polyvinyl acetal resin contained, and very less in the thermal decomposition residue of the ceramic green sheet itself and black carbon resulting from the thermal decomposition residue was not recognized in comparison with the ceramic green sheets obtained in Comparative Examples 29 to 35.

INDUSTRIAL APPLICABILITY

According to the present invention, it is possible to provide the modified polyvinyl acetal resin, which is superior in flexibility, an adhesive property to a resin substrate under high humidities, heat resistance, a thermal decomposition property, humidity resistance and toughness and has low oxygen permeability and an adequate adhesive property and is low in viscosity and high in secular stability of viscosity in forming a solution thereof to be used in the slurry composition for a ceramic green sheet, and the ceramic green sheet.

**Claims**

1. A slurry composition for a ceramic green sheet, which contains:

   - a modified polyvinyl acetal resin obtained by acetalizing a modified polyvinyl alcohol having ethylene on a random basis as a constituent unit of a main chain and an ethylene content of 1 to 20 mole % and a saponification degree of 80 mole % or more;
   - ceramic powder;
   - a plasticizer; and
   - an organic solvent.

2. A ceramic green sheet, which is obtainable by configuring in sheet form and drying the slurry composition for a ceramic green sheet according to claim 1.

**Patentansprüche**

1. Aufschlämmzusammensetzung für eine keramische Grünfolie, welche umfaßt:

   - ein modifiziertes Polyvinylacetalharz, das durch Acetalbildung eines modifizierten Polyvinylalkohols, der Ethylen auf einer willkürlichen Basic als konstituierende Einheit einer Hauptkette und einen Ethylengehalt von 1 bis 20 Mol-% und einen Verseifungsgrad von 80 Mol-% oder mehr besitzt, gebildet wird,
   - keramisches Pulver,
   - einen Weichmacher und
   - ein organisches Lösungsmittel.

2. Keramische Grünfolie, welche durch Formen in Folienform und Trocknen der Aufschlämmungszusammensetzung für eine keramische Grünfolie nach Anspruch 1 erhältlich ist.

**Revendications**

1. Composition de suspension pour une feuille céramique à l'état vert, laquelle contient :

   - une résine de polyvinylacétal modifiée obtenue par acétalisation d'un poly(alcool vinylique) modifié présentant de l'éthylène sur une base aléatoire comme unité constituante d'une chaîne principale et une teneur en éthylène de 1 à 20 % en mol et un degré de saponification de 80 % en mol ou supérieur ;
   - de la poudre céramique ;
   - un plastifiant ; et
   - un solvant organique.

2. Feuille céramique à l'état vert, laquelle peut être obtenue par configuration dans une forme de feuille et séchage de la composition de suspension pour une feuille céramique à l'état vert selon la revendication 1.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP HEI6263521 B
- JP HEI11349889 B
- JP HEI3197511 B
- JP HEI3200805 B
- JP HEI4175261 B
- JP HEI4178404 B